# EUROPÄISCHE PATENTSCHRIFT

(11) **EP 0 369 309 B1**
(45) Veröffentlichungstag und Bekanntmachung des Hinweises auf die Patenterteilung: **06.07.1994**
(21) Anmeldenummer: 89120670.8
(22) Anmeldetag: 08.11.1989
(51) Int. Cl.: H01L 39/24

(54) **Verfahren zum Herstellen von hochtemperatur-supraleitenden duktilen Verbundwerkstoffen und nach dem Verfahren hergestelltes Verbundmaterial**
Process for producing high-temperature superconducting ductile composite materials, and composites produced by this process
Procédé de fabrication d'un composite ductile supraconducteur à haute température et composites fabriqués par ce procédé

(30) Priorität: 15.11.1988 DE 3838670
(43) Veröffentlichungstag der Anmeldung: 23.05.1990
(73) Patentinhaber: Berkenhoff GmbH, D-35452 Heuchelheim (DE)
(72) Erfinder: Schmitz, Georg, Dipl.-Phys., D-5100 Aachen (DE); Weiss, Hartmut, D-5100 Aachen (DE); Wolters, Christian, D-5100 Aachen (DE)
(74) Vertreter: Missling, Arne, Dipl.-Ing.

(56) Entgegenhaltungen:
- EP-A- 0 281 474
- EP-A- 0 285 168
- APPLIED PHYSICS LETTERS, Band 51, Nr. 3, Juli 1987, Seiten 203-204, American Institute of Physics, New York, US; S. JIN et al.: "High Tc superconductors - composite wire fabrication"
- APPLIED PHYSICS LETTERS, Band 52, Nr. 24, 13. Juni 1988, Seiten 2066-2067, American Institute of Physics, New York, US; P.N. PETERS et al.: "Observation of enhanced properties in samples of silver oxide doped YBa2Cu30x"

## Beschreibung

Die Erfindung betrifft ein Verfahren zum Herstellen von hochtemperatur-supraleitenden duktilen Verbundwerkstoffen mit Komponenten aus der Gruppe der Seltenerdemetalle sowie des Bariums und des Kupfers, die in Form mindestens einer oxidischen Verbindung (SE)₁Ba₂Cu₃O₇₋ₓ mit "x" kleiner als oder kleiner gleich 0,5 in eine Matrix aus mindestens einem Metall mit geringer Sauerstoffaffinität eingebettet sind.

Unter "Hochtemperatur-Supraleitern" werden derzeit solche Supraleiter verstanden, die oberhalb der Siedetemperatur des flüssigen Stickstoffs, also oberhalb von 77 K supraleitend sind. Die hierfür geeigneten oxidischen Verbindungen, die der im Oberbegriff genannten Summenforme 1 entsprechen, lassen sich verhältnismäßig leicht herstellen, sie haben eine oberhalb der genannten Siedetemperatur liegende Sprungtemperatur von 92 K.

Durch die EP-A-0286289 sowie durch den Aufsatz von Yurek/Vander Sande/Rudman/Chiang "SUPERCONDUCTING MICRO-COMPOSITES BY OXIDATION OF METALLIC PRECURSORS", veröffentlicht in "JOURNAL OF METALS" Vol. 40, No. 1, Januar 1988, S. 16 bis 18, sind Verfahren bekannt, bei denen einige oxidische Verbindungen der im Oberbegriff angegebenen Summenformel entsprechen und Edelmetalle als Matrixmetalle verwendet werden. Dabei wird jedoch zunächst aus den Oxidbildnern SE, Ba und Cu und dem Edelmetall eine Legierung hergestellt, die jedoch nicht für alle Metalle und alle Mischungsverhältnisse frei mischbar ist. Die betreffenden Legierungen sind duktil. Durch nachfolgende Oxidation entsteht dabei die genannte oxidische Verbindung in einer Matrix aus dem (nicht oxidierten) Edelmetall. Hierfür müssen jedoch enorm lange Oxidationszeiten inkauf genommen werden. Eine gerichtete Erstarrung ist nicht beschrieben und tritt auch bei den beschriebenen Erstarrungverfahren nicht auf, die sämtlich der Bedingung einer "schnellen Verfestigung" genügen müssen.

Während das vorstehend beschriebene Verfahren als Lösung für das Problem angesehen wird, aufgrund der gegeben Duktilität hochtemperatur-supraleitende Drähte und Bänder herstellen zu können, ist die sogenannte Stromtragfähigkeit J_{c} bei Abwesenheit magnetischer Felder mit etwa 500 A/cm² und bei einem magnetischen Feld von H = 1 tesla mit etwa 1 A/cm² extrem gering und ungenügend für kommerzielle Anwendungen.

Die Autoren Jin/Tiefel/Sherwood/Davis/van Dover/Kamlott/Fastnacht/Keith haben in einer Veröffentlichung in Appl. Phys.Lett. 52, 1988, S.2074 ff., unter dem Titel "HIGH CRITICAL CURRENTS IN Y-Ba-Cu-O SUPERCONDUCTORS" die vorstehenden Werte für polykristallines, nicht orientiertes Material genannt und einen Weg gezeigt, mittels des Verfahrens der gerichteten Erstarrung, die genannten Werte auf etwa 17.000 A/cm² (feldfrei) und 4.000 A/cm² (in einem Feld von H = 1 tesla) drastisch zu erhöhen. Dieses rein keramische Material ist jedoch außerordentlich spröde und für die Herstellung dünner Bänder und Drähte nicht geeignet.

Durch die EP-A-0300215 gehört auch ein Verfahren der eingangs beschriebenen Gattung zum Stande der Technik nach Artikel 54 (3) EPÜ, bei dem für Kupfer als Matrixmetall eine Temperaturgrenze von 300°C und für Silber eine Temperatur von 600°C angeben wird. Dabei erfolgt kein Aufschmelzen der surpraleitenden oxidischen Materialien, deren Schmelzbereich für das weiter unten beschriebenen Yttrium-System je nach Sauerstoffgehalt mit etwa 1030 bis 1050 °C umrissen werden kann. Für andere Systeme der gleichen Art liegen die Schmelztemperaturen in der gleichen Größenordnung. Infolgedessen ist auch keine gerichtete Erstarrung möglich, die die Überschreitung der Schmelztemperatur voraussetzt.

Bei diesem bekannten Verfahren entstehen an den Korngrenzen in großer Zahl Schwachstellen, sogenannte "weak links", die die Stromtragfähigkeit ganz wesentlich herabsetzen. Die angegebene kritische Stromdichte von 10⁴ A/cm² kann sich daher auch nur auf Messungen ohne Vorhandensein eines äußeren Magnetfeldes beziehen. Für die Anwendung bei Spulen ist es jedoch entscheidend, daß auch unter dem Einfluß eines äußeren Magnetfeldes eine ausreichend hohe kritische Stromtragfähigkeit vorhanden ist. Die "weak links" wirken sich jedoch schon bei einem äußeren Magnetfeld von 1 Tesla negativ aus. Typische Werte für J_{c} liegen bei polykristallinem, gesintertem Material bei nur etwa 10² A/cm². Aus dem beschriebenen Verdichtungsprozeß ergibt sich die Forderung nach möglichst kleiner Korngröße; viele Korngrenzen aber bedeuten viele "weak links".

Durch die EP-A-02 85 960 ist es bekannt, Legierungen aus den metallischen Komponenten der Hochtemperatur-Supraleiter herzustellen, die insbesondere aufgrund einer sog. "Rasch-erstarrungstechnik" amorph bzw. feinkristallin und ausreichend duktil sind. Es sind jedoch die aus diesen Legierungen hergestellten, nicht supraleitenden Zwischenprodukte, die einem Verformungsprozeß unterwerden werden. Erst danach erfolgt die oxidative Temperaturbehandlung, die zu supraleitenden, aber spröden Endprodukten führt. Es sind weder Metall-Matrix-Verbundwerkstoffe noch das Verfahren einer gerichteten Erstarrung angesprochen.

Der Erfindung liegt daher die Aufgabe zugrunde, ein Verfahren zum Herstellen von bei hohen Temperaturen, d.h. solchen oberhalb 77 K, supraleitenden duktilen Verbundmaterialien anzugeben, bei denen sich eine hohe Stromtragfähigkeit und eine gute Duktilität für eine hohe Beanspruchung (elastische Verformung) zur Weiterverarbeitung miteinander vereinen.

Die Lösung der gestellten Aufgabe erfolgt dabei erfindungsgemäß durch ein eingangs näher bezeichnetes Verfahren, bei dem
a) ein Gemisch, das eine oder mehrere oxidische Verbindungen (SE)₁Ba₂Cu₃O₇₋ₓ und das die Matrix bildende Material in möglichst feiner und homogener Verteilung enthält, zu einem Rohling mit möglichst hoher Dichte verpreßt wird,
b) der Rohling auf eine solche Temperatur von mindestens 900°C aufgeheizt wird, daß zumindest örtlich der Schmelzpunkt der oxidischen Verbindung(en) überschritten ist,
c) eine gerichtete Erstarrung des Rohlings zu einem Formkörper durchgeführt wird und
d) der gerichtet erstarrte Formkörper in einer sauerstoffhaltigen Atmosphäre auf eine Temperatur von mindestens 300°C aufgeheizt und diese Wärmebehandlung so lange fortgesetzt wird, bis "x" kleinstmöglich, maximal aber gleich 0,5 ist.

Das Verfahren der "gerichteten Erstarrung" ist in der Verfahrenstechnik fest etabliert: Es handelt sich darum, durch einen Formkörper oder eine Schmelze unter Einhaltung eines definierten Temperaturgradienten in Wanderungsrichtung eine Erstarrungsfront hindurchzuführen, hinter der sich ein monokristallines oder polykristallines Gefüge mit einer bestimmten Wachstumsrichtung oder auch nur Vorzugsrichtung kontinuierlich aufbaut. Ein bekanntes Verfahren ist das Verfahren nach BRIDGMAN, eine Vorrichtung zur Durchführung dieses Verfahrens der weiter unten beschriebene Bridgman-Ofen, bei dem eine Heizzone und eine Kühlzone durch eine Wärmedämmung voneinander getrennt sind, innerhalb welcher in Achsrichtung des Formköpers der erforderliche Temperaturgradient eingestellt werden kann.

Die mit dem Erfindungsgegenstand erzielbaren Vorteile bestehen darin, daß die so hergestellten Hochtemperatur-Supraleiter aufgrund ihrer ausreichenden Duktilität und hohen Stromtragfähigkeit für technische Anwendungen z.B. zum Ziehen von Drähten geeignet sind, die dann einer Anwendung ähnlich derjenigen konventioneller Supraleiter zugeführt werden können. Es ergeben sich hieraus erhebliche Kostenvorteile, da die bei konventionellen Supraleitern notwendige Kühlung mit flüssigem Helium durch die weitaus preiswertere Kühlung mit flüssigem Stickstoff ersetzt werden kann. Dies führt zu neuen Anwendungen, bei denen die Verwendung konventioneller Supraleiter bisher aus Kostengründen nicht in Betracht gezogen worden ist.

Es ist dabei überraschend, daß eine gerichtetet Erstarrung bei einem "Composite"-Werkstoff (Keramik in Metallmatrix) zu dem gewünschten Ergebnis führt.

Erfindungsgemäß kann die Matrix unmittelbar aus einem Metall mit geringer Sauerstoffaffinität erzeugt werden. Es ist aber auch möglich, ein reduzierfähiges Oxid dieses Metalls einzusetzen, z.B. Silberoxid, das leicht Sauerstoff abspaltet, um dadurch bei der späteren Sauerstoffbehandlung der oxidischen Verbindung einen Sauerstoffvorrat im Festkörper zur Verfügung zu haben. Ferner können durch eine solche Maßnahme auch Rohlinge mit großen Abmessungen eingesetzt werden, weil dann die Reaktionsdauer nicht mehr oder nicht mehr ausschließlich durch die große Diffusionsweglänge für den Sauerstoff bedingt ist. Der Sauerstoff ist zumindest teilweise bereits im Kern des Formkörpers vorhanden.

Während es möglich ist, die Festkörperreaktion und die gerichtete Erstarrung gewissermaßen in einer Hitze durchzuführen, ist es für eine gezielte Steuerung der einzelnen Verfahrensablaufe von besonderem Vorteil, wenn man
a) in einem ersten Verfahrensschritt die besagte oxidische Verbindung durch eine Festkörperreaktion von Verbindungen der obigen Komponenten herstellt, wobei man zweckmäßig das gesinterte (Zwischen-)Produkt dieses ersten Verfahrensschritts wieder zu einem Pulver zerkleinert,
b) in einem zweiten Verfahrensschritt ein Gemisch, das die besagte oxidische Verbindung und das die Matrix bildende Metall bzw. ein zu diesem Metall reduzierbares Oxid in möglichst feiner und homogener Verteilung enthält, zunächst auf eine Temperatur aufheizt, die unterhalb des Schmelzpunktes des Matrixmetalls liegt, bis die Partikel der besagten oxidischen Verbindung unter Bildung eines Rohlings eine Vernetzung eingehen,
c) in einem dritten Verfahrensschritt den Rohling zumindest örtlich auf eine Temperatur oberhalb des Schmelzpunktes der oxidischen Verbindung aufheizt und ihn unter Bildung eines Formkörpers der gerichteten Erstarrung unterwirft und schließlich
d) in einem vierten Verfahhrensschritt den Formkörper der Sauerstoffbehandlung gemäß Merkmal b) in Anspruch 1 aussetzt.

Gute Ergebnisse konnten insbesondere beim Einsatz von Seltenerdmetallkomponenten aus der Gruppe Yttrium und Ytterbium beobachtet werden.

Um die Festkörperreaktion des ersten Verfahrensschritts nach Anspruch 2 zu beschleunigen, kann man dabei besonders zweckmäßig so verfahren, daß man die Ausgangsverbindungen für die oxidische Verbindung den molaren Verhältnissen der Metalle in der Verbindung entsprechend mischt, die Mischung zu Formkörpern mit einem möglichst großen Verhältnis von Oberfläche : Volumen verpreßt, beispielsweise zu dünnen Tabletten, und diese Formkörper in sauerstoffhaltiger Amtmosphäre auf eine Sintertemperatur von mindestens 900 °C aufheizt und die Temperaturbehandlung fortsetzt, bis der Sinterprozeß zumindest weitgehend abgeschlossen ist, und daß man die Formkörper nachfolgend wieder zu einem möglichst feinen Pulver zerkleinert.

Ein bevorzugtes Ausführungsbeispiel besteht darin, daß man im ersten Verfahrensschritt gemäß Anspruch 2 als Ausgangskomponenten Yttriumoxid, Bariumkarbonat und Kupferoxid im molaren Verhältnis Y:Ba:Cu = 1:2:3 mischt, die gepreßten Formkörper in Sauerstoffatmosphäre bei einem Sauerstoff-Partialdruck von minmdestens 0,2 bar auf eine Temperatur zwischen 900 und 1000 °C aufheizt und bis zur Bildung von Y₁Ba₂Cu₃O₇₋ₓ für die Dauer von 10 bis 30 Stunden in diesem Temperaturbereich hält (wobei "x" wiederum kleiner oder gleich 0,5), nachfolgend die Formköper mit einer Abkühlrate zwischen 50 und 200 K pro Stunde auf eine Temperatur zwischen 300 und 500 °C abkühlt und in diesem Temperaturbereich 2 bis 5 Stunden unter Sauerstoffatmosphäre hält und sie anschließend zerkleinert.

Bei Verwendung von Silber als Matrixmetall ist es besonders zweckmäßig, wenn man das Volumensverhälnis zwischen der oxidischen Verbindung und dem Silber zwischen (0,8 und 1,2) : 1 wählt.

Will man aus dem Composite-Material beispielsweise Drähte ziehen, ist es besonders zweckmäßig, wenn man Rohling bzw. Formkörper mit einer zylindrischen Außenfläche herstellt. Man verfährt dann besonders zweckmäßig so, daß man den Rohling in einen rohrförmigen Behälter, vorzugsweise in einen solchen aus Aluminiumoxid, einsetzt, ihn in diesem Behälter zunächst einem Vernetzungsvorgang bei einer Temperatur unterhalb des Schmelzpunktes des Matrixmetalls aussetzt und ihn nachfolgend unter Ausführung einer gerichteten Erstarrung mittels einer axialen Relativbewegung mit einer Geschwindigkeit von größenordnungsmäßig 0,1 mm/min durch die Gradienten-Zone eines Bridgman-Ofens hindurchführt, wobei im Bereich vor der Erstarrungsfront eine Mindesttemperatur von 1100 °C und ein axialer Temperaturgradient von 50 bis 150 °C erzeugt wird.

Bei der Durchführung des Verfahrens nach Anspruch 1 geht man zweckmäßigerweise so vor, daß man beim Verfahrensschritt b) eine Temperatur zwischen 900 und 950 °C einstellt.

Die Erfindung betrifft schließlich auch ein Hochtemperatur-Supraleiter-Verbundmaterial nach dem Oberbegriff des Patentanspruchs 15.

Zur Lösung der gleichen Aufgabe ist ein solcher Composite-Supraleiter erfindungsgemäß gekennzeichnet durch die im Kennzeichen des Patentanspruchs 15 angegebenen Merkmale.

Gute Ergebnisse haben sich bei Verwendung der oxidischen Verbindung Y₁Ba₂Cu₃O₇₋ₓ mit Silber als Matrixmetall gezeigt, wobei das Volumensverhältnis der oxidischen Verbindung zum Silber zwischen (0,8 und 1,2) : 1 beträgt.

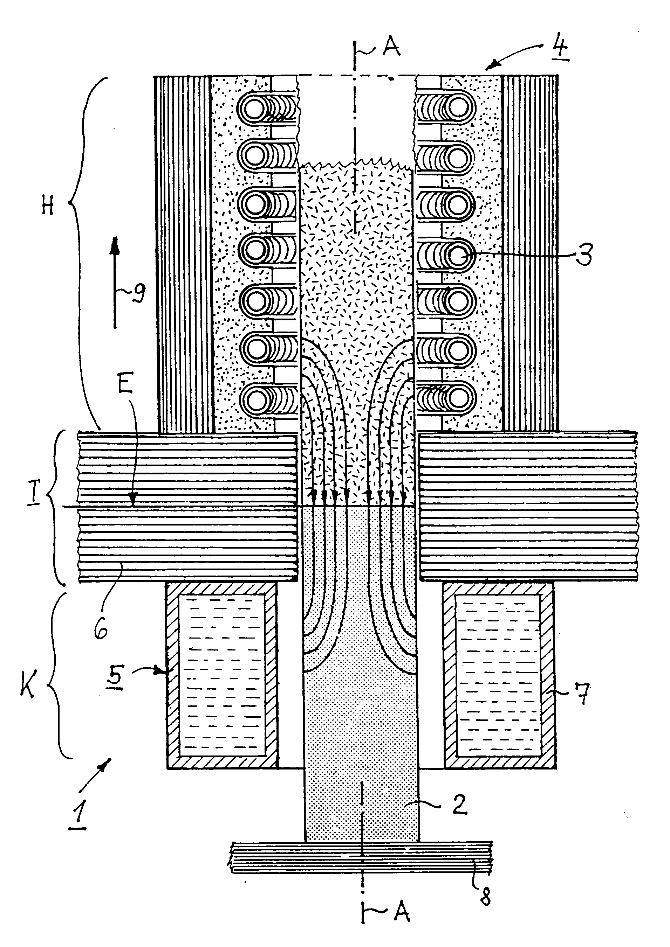

In der Figur ist ein vertikaler Axialschnitt durch einen BRIDGEMAN-Ofen 1 und einen in diesem befindlichen zylindrischen Formkörper 2 mit einer Achse A-A während des Ablaufs der gerichtete Erstarrung gezeigt. Der Ofen 1 enthält eine mit Heizwiderständen 3 versehene Heizeinrichtung 4, die eine Heizzone "H" bildet und von einer darunter befindlichen Kühleinrichtung 5 durch einen Isolierkörper 6 getrennt ist. Dieser bildet eine Isolationszone "I", in der sich ein Temperaturgradient T von beispielhaft 100 °C pro cm (in Richtung der Achse A-A) einstellt. Die Kühleinrichtung 5 bildet eine Kühlzone "K" und besteht aus einem Hohlzylinder 7, der von einem flüssigen Kühlmedium (Wasser) durchströmt wird. Der Wärmestrom ist durch Linien mit Pfeilen angedeutet. Der Formkörper 2 stützt sich auf einer Unterlage 8 ab.

Die Heizeinrichtung 4 ist derart leistungsfähig, daß sich durch ihren Einfluß im Formkörper 2 eine Temperatur von mindestens 1100 °C einstellen kann. Dadurch bildet sich im Formkörper eine Erstarrungsfront "E" aus, die möglichst eben und waagrecht verläuft, bei einem zylindrischen Formkörper also zumindest angenähert in einer Kreisfläche liegt. Durch eine Relativbewegung zwischen Formkörper 2 und Ofen 1 in Richtung des Pfeils 9 wandert die Erstarrungfront in Achsrichtung nach oben. Die Antriebseinrichtung ist bekannt und daher nicht dargestellt. Das Material oberhalb der Erstarrungfront ist ungeordnet (wahllose Raumlage der Partikel), dasjenige unterhalb der Erstarrungsfront gerichtet erstarrt.

### Beispiel:

### 1. Herstellen von Y₁Ba₂Cu₃O₇₋ₓ:

Y₂O₃, BaCO₃ und CuO werden im molaren Verhältnis ihrer Metallkomponenten Y:Ba:Cu von 1:2:3 gemischt, im Mörser behandelt und in einer Pulverpresse bei 150 bar zu Tabletten mit einer Dicke von 1 mm und einem Durchmesser von 20 mm gepreßt. Diese Tabletten werden halbiert und in einem Aluminiumoxid-Schiffchen in einen Temperungsofen gebracht. Dort werden sie in einer Sauerstoffatmosphäre von 1 bar Partialdruck (= reiner Sauerstoff) mit einer Steigerungsrate von 20 K pro Minute auf 950 °C aufgeheizt, 20 Stunden unter diesen Bedingungen gehalten und anschließend mit einer Absenkrate von 100 K pro Stunde auf 350 °C abgekühlt, noch für 3 Stunden unter Sauerstoff bei dieser Temperatur gehalten, schließlich dem Ofen entnommen und in einem Mörser gemahlen, wodurch das feine oxidische Ausgangsmaterial für den nachfolgenden 2. Verfahrensschritt erhalten wird.

### 2. Herstellen des Rohlings:

Gleiche Volumina des Oxidpulvers aus dem 1. Verfahrensschritt und von Silberpulver etwa gleichen Feinheitsgrades werden sorgfälig gemischt und durch Pressen zu einem möglichst dichten Zylinder mit einem Durchmesser von 10 mm und einer Länge von 150 mm geformt. Die hohe Dichte dieses Preßlings, die sich durch einen hohen Preßdruck in einer entsprechenden Preßform möglichst weitgehend der theoretischen Dichte von 100 % annähern sollte, ist von ganz besonderer Bedeutung, um Gaseinschlüsse, Poren o. dgl. auszuschließen. Der Preßling wird dann in ein Rohr aus Aluminiumoxid mit etwa gleichem Innendurchmesser eingesetzt und vollständig in das Innere des Bridgeman-Ofens eingeschoben und der Ofen zunächst auf 880 °C, eine Temperatur unterhalb des Schmelzpunktes des Matrixmetalls, aufgeheizt (der Schmelzpunkt von Silber liegt bei 960 °C) und bei dieser Temperatur 1 Stunde belassen, bis die Vernetzung der Partikel der oxidischen Verbindung (aus dem Verfahrenschritt 1) und die Bildung des Rohlings stattgefunden hat.

### 3. Gerichtetes Erstarren und Bilden des Formkörpers:

Die Temperatur des Bridgeman-Ofens wurde anschließend auf 1230 °C hochgefahren, der Rohling entsprechend aufgeheizt und anschließend der Vorschub mit einer konstanten axialen Geschwindigkeit von 0,05 mm/min eingeschaltet. Gemäß dem anhand der Figur beschriebenen Verfahren wurde auf diese Weise die Erstarrungsfront mit einer entsprechenden Geschwindigkeit und einem gemessenen Temperaturgradienten von 100 °C prom cm Länge des Rohlings in Achsrichtung durch den Rohling hindurchbewegt, wodurch das gerichtet erstarrte Gefüge des "Composites" d.h. von Silber und Keramik und der Formkörper entstand.

### 4. Aufoxidieren des Formkörpers:

Nachdem das Aluminiumoxid-Rohr mit dem Formkörper vollständig aus dem Ofen herausgefahren worden war, wurde der notwendige Sauerstoffgehalt ("x" = kleinstmöglich = Supraleitung) der oxidischen Anteile des Formkörpers auf folgende Weise eingestellt: Der Formkörper wurde dem Al₂O₃-Rohr entnommen und in einem Schiffchen aus dem gleichen Werkstoff in einen Temperofen geschoben, in diesem auf 920 °C aufgeheizt und unter Sauerstoff mit einem Partialdruck von 1 bar für die Dauer von 48 Stunden gehalten. Danach wurde der Formkörper mit einer Abnahmerate von 60 K pro Stunde abgekühlt. Die im Vergleich zum Sintern (erster Verfahrensschritt) langen Temperungs- und Abkühlzeiten waren notwendig, um der langen Diffusionsweglänge für den Sauerstoff bis zum Kern des Formkörpers Rechnung zu tragen. Der Sauerstoffeinfluß ist auch beim Durchfahren der Temperaturzone zwischen 400 und 300 °C besonders groß. Der Zeitaufwand des Aufoxidierens kann dadurch wesentlich abgekürzt werden, daß man den Formkörper zuvor zu einem Draht auszieht oder zu einer Folie auswalzt. Nach dieser Abschlußbehandlung lag der Hochtemperatur-Supraleiter in seinem Endzustand vor.

## Patentansprüche

1. Verfahren zum Herstellen von hochtemperatur-supraleitenden duktilen Verbundwerkstoffen mit Komponenten aus der Gruppe der Seltenerdmetalle (SE) sowie des Bariums (Ba) und des Kupfers (Cu), die in Form mindestens einer oxidischen Verbindung (SE)₁Ba₂Cu₃O₇₋ₓ mit "x" kleiner als oder gleich 0,5 in eine Matrix aus mindestens einem Metall mit geringer Sauerstoffaffinität eingebettet sind, wobei
a) ein Gemisch, das eine oder mehrere oxidische Verbindungen mit obiger Summenformel und das die Matrix bildende Material in möglichst feiner und homogener Verteilung enthält, zu einem Rohling mit möglichst hoher Dichte verpreßt wird,
b) der Rohling auf eine solche Temperatur von mindestens 900°C aufgeheizt wird, daß zumindest örtlich der Schmelzpunkt der oxidischen Verbindung(en) überschritten ist,
c) eine gerichtete Erstarrung des Rohlings zu einem Formkörper durchgeführt wird und
d) der gerichtet erstarrte Formkörper in einer sauerstoffhaltigen Atmosphäre auf eine Temperatur von mindestens 300°C aufgeheizt und diese Wärmebehandlung so lange fortgesetzt wird, bis "x" kleinstmöglich, maximal aber gleich 0,5 ist.

2. Verfahren nach Anspruch 1, dadurch gekennzeichnet, daß man
a) in einen ersten Verfahrensschritt die besagte oxidische Verbindung durch eine Festkörperreaktion von Verbindungen der obigen Komponenten herstellt,
b) in einem zweiten Verfahrensschritt das Gemisch, das die besagte oxidische Verbindung und das die Matrix bildende Metall bzw. ein zu diesem Metall reduzierbares Oxid in möglichst feiner und homogener Verteilung enthält, zunächst auf eine Temperatur aufheizt, die unterhalb des Schmelzpunktes des Matrixmetalls liegt, bis die Partikel der besagten oxidischen Verbindung unter Bildung eines Rohlings eine Vernetzung eingehen,
c) in einem dritten Verfahrensschritt den Rohling zumindest örtlich auf eine Temperatur oberhalb des Schmelzpunktes der oxidischen Verbindung aufheizt und ihn unter Bildung eines Formkörpers der gerichteten Erstarrung unterwirft und
d) in einem vierten Verfahhrensschritt den Formkörper der Sauerstoffbehandlung gemäß Merkmal b) in Anspruch 1 aussetzt.

3. Verfahren nach Anspruch 1, dadurch gekennzeichnet, daß man als das die Matrix bildende Material das entsprechende Metall verwendet.

4. Verfahren nach Anspruch 1, dadurch gekennzeichnet, daß man als das die Matrix bildende Material ein zu dem entsprechenden Metall reduzierbares Oxid verwendet.

5. Verfahren nach Anspruch 1, dadurch gekennzeichnet, daß man als das die Matrix bildende Metall Silber bzw. Silberoxid verwendet.

6. Verfahren nach Anspruch 1, dadurch gekennzeichnet, daß man Seltenerdmetallkomponenten aus der Gruppe Yttrium und Ytterbium verwendet.

7. Verfahren nach Anspruch 2, dadurch gekennzeichnet, daß man die Ausgangsverbindungen für die oxidische Verbindung den molaren Verhältnissen der Metalle in der Verbindung entsprechend mischt, die Mischung zu Formkörpern mit einem möglichst großen Verhältnis von Oberfläche : Volumen verpreßt und diese Formkörper in sauerstoffhaltiger Amtmosphäre auf eine Sintertemperatur von mindestens 900 °C aufheizt und die Temperaturbehandlung fortsetzt, bis der Sinterprozeß zumindest weitgehend abgeschlossen ist, und daß man die Formkörper nachfolgend wieder zu einem möglichst feinen Pulver zerkleinert.

8. Verfahren nach Anspruch 2, dadurch gekennzeichnet, daß man im ersten Verfahrensschritt als Ausgangskomponenten Yttriumoxid, Bariumkarbonat und Kupferoxid im molaren Verhältnis Y:Ba:Cu = 1:2:3 mischt, die gepreßten Formkörper in Sauerstoffatmosphäre bei einem Sauerstoff-Partialdruck von minmdestens 0,2 bar auf eine Temperatur zwischen 900 und 1000 °C aufheizt und bis zur Bildung von Y₁Ba₂Cu₃O₇₋ₓ für die Dauer von 10 bis 30 Stunden in diesem Temperaturbereich hält, nachfolgend die Formkörper mit einer Abkühlrate zwischen 50 und 200 K pro Stunde auf eine Temperatur zwischen 300 und 500 °C abkühlt und in diesem Temeraturbereich 2 bis 5 Stunden unter Sauerstoffatmosphäre hält und sie anschließend zerkleinert.

9. Verfahren nach Anspruch 1, dadurch gekennzeichnet, daß man das Volumenverhältnis der besagten oxidischen Verbindung zum Matrixmetall zwischen (0,5 und 1,5) : 1 wählt.

10. Verfahren nach den Ansprüchen 5 und 8, dadurch gekennzeichnet, daß man das Volumenverhälnis zwischen der oxidischen Verbindung und dem Silber zwischen (0,8 und 1,2) : 1 wählt.

11. Verfahren nach Anspruch 1, dadurch gekennzeichnet, daß man Rohling und Formkörper mit einer zylindrischen Außenfläche herstellt.

12. Verfahren nach Anspruch 11, dadurch gekennzeichnet, daß man den Rohling in einen rohrförmigen Behälter einsetzt, ihn in diesem zunächst einem Vernetzungsvorgang bei einer Temperatur unterhalb des Schmelzpunktes des Matrixmetalls aussetzt und ihn nachfolgend unter Ausführung einer gerichteten Erstarrung mittels einer axialen Relativbewegung mit einer Geschwindigkeit von größenordnungsmäßig 0,1 mm/min durch einen Bridgman-Ofen hindurchführt, wobei im Bereich vor der Erstarrungsfront eine Mindesttemperatur von 1100 °C erzeugt wird.

13. Verfahren nach Anspruch 12, dadurch gekennzeichnet, daß man im Bereich der Erstarrungfront einen axialen Temperaturgradienten von 50 bis 150 °C erzeugt.

14. Verfahren nach Anspruch 1, dadurch gekennzeichnet, daß man beim Verfahrensschritt b) eine Temperatur zwischen 900 und 950 °C einstellt.

15. Hochtemperatur-Supraleiter-Verbundmaterial mit Komponenten aus der Gruppe der Seltenerdmetalle (SE) sowie des Bariums und des Kupfers, die in Form der oxidischen Verbindung (SE)₁Ba₂Cu₃O₇₋ₓ in eine Matrix aus mindestens einem Metall mit geringer Sauerstoffaffinität eingebettet sind, wobei "x" kleiner oder gleich 0,5 ist, dadurch gekennzeichnet, daß das Verbundmaterial eine Vorzugsrichtung aufweist und die Partikel der oxidischen Verbindung miteinander vernetzt sind.

16. Verbundmaterial nach Anspruch 15, dadurch gekennzeichnet, daß die oxidische Verbindung Y₁Ba₂Cu₃O₇₋ₓ und das Matrixmetall Silber ist.

17. Verbundmaterial nach Anspruch 16, dadurch gekennzeichnet, daß das Volumenverhältnis der oxidischen Verbindung zum Silber zwischen (0,8 und 1,2) : 1 beträgt.

## Claims

1. A process for producing high-temperature superconducting ductile composite materials with components from the group of rare-earth metals (RE) and of barium (Ba) and of copper (Cu), which are embedded in the form of at least one oxide compound (RE)₁Ba₂Cu₃O₇₋ₓ with "x" less than or equal to 0·5 in a matrix of at least one metal with a low oxygen affinity, wherein
a) a mixture which contains one or more oxide compounds with the above summation formula and the material forming the matrix in as fine and homogeneous a distribution as possible is pressed to form a blank with as high a density as possible,
b) the blank is heated to such a temperature of at least 900°C that the melting point of the oxide compound or compounds is exceeded at least locally,
c) a directional solidification of the blank to form a moulded body is performed, and
d) the directionally solidified moulded body is heated in an oxygen-containing atmosphere to a temperature of at least 300°C and this heat treatment is continued until "x" is as small as possible, but at most equal to 0·5.

2. A process according to Claim 1, **characterized in that**
a) in a first process step the said oxide compound is produced by a solid-body reaction of compounds of the above components,
b) in a second process step the mixture, which contains the said oxide compound and the metal forming the matrix or an oxide reducible to the said metal in as fine and homogeneous a distribution as possible, is first heated to a temperature below the melting point of the matrix metal until the particles of the said oxide compound produce cross-linking while forming a blank,
c) in a third process step the blank is heated at least locally to a temperature above the melting point of the oxide compound and is subjected to the directional solidification while forming a moulded body, and
d) in a fourth process step the moulded body is subjected to the oxygen treatment according to feature b) in Claim 1.

3. A process according to Claim 1, **characterized in that** the corresponding metal is used as the material forming the matrix.

4. A process according to Claim 1, **characterized in that** an oxide reducible to the corresponding metal is used as the material forming the matrix.

5. A process according to Claim 1, **characterized in that** silver or silver oxide is used as the metal forming the matrix.

6. A process according to Claim 1, **characterized in that** rare-earth metal components from the group of yttrium and ytterbium are used.

7. A process according to Claim 2, **characterized in that** the starting compounds for the oxide compound are mixed in accordance with the molar ratios of the metals in the compound, the mixture is pressed to form moulded bodies with as high a ratio of surface to volume as possible, and these moulded bodies are heated in an oxygen-containing atmosphere to a sintering temperature of at least 900°C and the temperature treatment is continued until the sintering process is at least largely completed, and the moulded bodies are subsequently comminuted again to form as fine a powder as possible.

8. A process according to Claim 8, **characterized in that** in the first process step yttrium oxide, barium carbonate and copper oxide are mixed as starting components in a molar ratio of Y : Ba : Cu= 1 : 2 : 3, the pressed moulded bodies are heated to a temperature of between 900 and 1000°C in an oxygen atmosphere with a partial pressure of oxygen of at least 0·2 bar and are kept in this temperature range for a duration of from 10 to 30 hours until Y₁Ba₂Cu₃O₇₋ₓ is formed, the moulded bodies are then cooled to a temperature of between 300 and 500°C at a cooling rate of between 50 and 200 K *per* hour and are kept in this temperature range for between 2 and 5 hours under an oxygen atmosphere and are subsequently comminuted.

9. A process according to Claim 1, **characterized in that** the volume ratio of the said oxide compound to the matrix metal is selected to be between (0·5 and 1·5) : 1.

10. A process according to Claims 5 and 8, **characterized in that** the volume ratio between the oxide compound and the silver is selected to be between (0·8 and 1·2) : 1.

11. A process according to Claim 1, **characterized in that** the blank and the moulded body are produced with a cylindrical outer surface.

12. A process according to Claim 11, **characterized in that** the blank is placed in a tubular container, is subjected therein first to a cross-linking process at a temperature below the melting point of the matrix metal and is subsequently passed through a Bridgman furnace by an axial relative movement at a speed in the order of magnitude of 0·1 mm/min while a directional solidification takes place, wherein a minimum temperature of 1100°C is produced in the region in front of the solidification contour.

13. A process according to Claim 12, **characterized in that** an axial temperature gradient of from 50 to 150°C is produced in the region of the solidification contour.

14. A process according to Claim 1, **characterized in that** a temperature of between 900 and 950°C is set in process step b).

15. A high-temperature superconductor composite material with components from the group of rare-earth metals (RE) and of barium and of copper, which are embedded in the form of the oxide compound (RE)₁Ba₂Cu₃O₇₋ₓ in a matrix of at least one metal with a low oxygen affinity, wherein "x" is less than or equal to 0·5, **characterized in that** the composite material has a preferred direction and the particles of the oxide compound are cross-linked with one another.

16. A composite material according to Claim 15, **characterized in that** the oxide compound is Y₁Ba₂Cu₃O₇₋ₓ and the matrix metal is silver.

17. A composite material according to Claim 16, **characterized in that** the volume ratio of the oxide compound to silver is between (0·8 and 1·2) : 1.

## Revendications

1. Procédé de fabrication de composites ductiles supraconducteurs à haute température, avec des composants du groupe de métaux rares (TR) ainsi que du baryum (Ba) et du cuivre (Cu), qui sont, sous la forme d'au moins une combinaison oxydée (TR)₁Ba₂Cu₃O₇₋ₓ, avec "x" inférieur ou égal à 0,5, incorporés dans une matrice constituée d'au moins un métal présentant une faible affinité pour l'oxygène, procédé selon lequel :
a) un mélange, qui contient une ou plusieurs combinaisons oxydées correspondant à la formule globale ci-dessus et le matériau constituant la matrice, avec une répartition la plus fine et la plus homogène possible, est comprimé pour former une éprouvette présentant la densité la plus forte possible,
b) l'éprouvette est portée à une température d'au moins 900°C telle qu'au moins localement, le point de fusion de la ou des combinaisons oxydées soit dépassé,
c) une solidification orientée de l'éprouvette est effectuée pour obtenir un corps de forme,
d) le corps de forme obtenu par solidification orientée est chauffé, en atmosphère contenant de l'oxygène, à une température d'au moins 300°C et ce traitement thermique est poursuivi jusqu'à ce que "x" soit le plus petit possible, au maximum égal à 0,5.

2. Procédé suivant la revendication 1, caractérisé en ce que,
a) dans une première étape du procédé, la dite combinaison oxydée est réalisée par une réaction à l'état solide de combinaisons des composants ci-dessus,
b) dans une deuxième étape du procédé, le mélange qui contient la dite combinaison oxydée et le métal formant la matrice, ou un oxyde pouvant être réduit pour donner ce métal, avec la répartition la plus fine et la plus homogène possible, est d'abord chauffé à une température située en-dessous du point de fusion du métal de la matrice, jusqu'à ce que les particules de la dite combinaison oxydée arrivent à constituer un réseau, en formant une éprouvette,
c) dans une troisième étape du procédé, l'éprouvette est soumise, au moins localement, à une température située au-dessus du point de fusion de la combinaison oxydée, et est soumise à une solidification orientée en formant un corps de forme,
d) dans une quatrième étape du procédé, le corps de forme est soumis au traitement par l'oxygène conformément au point b) de la revendication 1.

3. Procédé suivant la revendication 1, caractérisé en ce qu'on utilise, comme matériau constituant la matrice, le métal correspondant.

4. Procédé suivant la revendication 1, caractérisé en ce qu'on utilise, comme matériau constituant la matrice, un oxyde pouvant être réduit pour donner le métal correspondant.

5. Procédé suivant la revendication 1, caractérisé en ce qu'on utilise, comme matériau constituant la matrice, de l'argent ou de l'oxyde d'argent.

6. Procédé suivant la revendication 1, caractérisé en ce qu'on utilise des composants de métaux des terres rares du groupe de l'yttrium et de l'ytterbium.

7. Procédé suivant la revendication 2, caractérisé en ce qu'on mélange les combinaisons initiales destinés à la combinaison oxydée d'une façon correspondant aux rapports molaires des métaux dans la combinaison, en ce qu'on comprime le mélange pour créer des corps de forme comportant un rapport surface externe : volume le plus grand possible, en ce qu'on chauffe ces corps de forme, sous atmosphère contenant de l'oxygène, à une température de frittage d'au moins 900°C et on poursuit le traitement thermique jusqu'à ce que l'opération de frittage soit au moins largement terminée, et en ce qu'on fragmente ensuite les corps de forme en une poudre la plus fine possible.

8. Procédé suivant la revendication 2, caractérisé en ce que, dans la première étape du procédé, on mélange, comme composants initiaux, de l'oxyde d'yttrium, du carbonate de baryum et de l'oxyde de cuivre dans le rapport molaire Y:Ba:Cu = 1:2:3, en ce qu'on chauffe les corps de forme, comprimés, sous atmosphère oxydante comportant une pression partielle en oxygène d'au moins 0,2 bars, à une température comprise entre 900 et 1000°C, en ce qu'on les maintient à cette température, jusqu'à formation de Y₁Ba₂Cu₃O₇₋ₓ, pour une durée de 10 à 30 heures, puis qu'on refroidit les corps de forme jusqu'à une température comprise entre 300 et 500°C, avec une vitesse de refroidissement comprise entre 50 et 200°K par heure, en ce qu'on maintient à cette zone de température pendant 2 à 5 heures, sous atmosphère oxydante, et puis en ce qu'enfin on les fragmente.

9. Procédé suivant la revendication 1, caractérisé en ce que l'on choisit, entre 0,5:1 et 1,5:1, le rapport volumique de la dite combinaison oxydée par rapport au métal de la matrice.

10. Procédé suivant la revendication 5 et la revendication 8, caractérisé en ce que l'on choisit entre 0,8:1 et 1,2:1, le rapport volumique de la combinaison oxydée par rapport à l'argent.

11. Procédé suivant la revendication 1, caractérisé en ce que l'on fabrique les éprouvettes et les corps de forme avec une surface externe cylindrique.

12. Procédé suivant la revendication 11, caractérisé en ce que l'on place l'éprouvette dans un récipient tubulaire, qu'on le soumet, dans celui-ci, à une opération de réticulation à une température située en-dessous du point de fusion du métal de la matrice et en ce qu'on le fait ensuite passer dans un four de Bridgman en effectuant une solidification orientée avec un mouvement relatif à une vitesse d'un ordre de grandeur de 0,1 mm/min, étant entendu que l'on réalise, dans la zone avant le front de solidification, une température minimale de 1100°C.

13. Procédé suivant la revendication 12, caractérisé en ce que l'on réalise, dans la zone du front de solidification, un gradient axial de température de 50 à 150°C.

14. Procédé suivant la revendication 1, caractérisé en ce que l'on établlit, pour l'étape b) du procédé, une température comprise entre 900 et 950°C.

15. Matériau composite ductile supraconducteur à haute température, comportant des composants du groupe de terres rares (TR) ainsi que du baryum (Ba) et du cuivre, qui, sous la forme d'au moins une combinaison oxydée (SE)₁Ba₂Cu₃O₇₋ₓ, avec x plus petit ou égal à 0,5, sont incorporés dans une matrice composée d'au moins un métal ayant une faible affinité pour l'oxygène, caractérisé en ce que le matériau composite présente une direction privilégiée et que les particules de la combinaison oxydée forment entre elles un réseau.

16. Matériau composite suivant la revendication 16, caractérisé en ce que la combinaison oxydée est Y₁Ba₂Cu₃O₇₋ₓ, et que le métal de la matrice est de l'argent.

17. Matériau composite suivant la revendication 17, caractérisé en ce que le rapport volumétrique de la combinaison oxydée par rapport à l'argent est compris entre 0,8:1 et 1,2:1.
